# EUROPEAN PATENT APPLICATION

(11) **EP 4 394 456 A2**
(43) Date of publication of application: **03.07.2024**
(21) Application number: 23216423.6
(22) Date of filing: 13.12.2023
(51) Int. Cl.: G01T 1/24, G01T 1/29

(54) **IMPROVED DETECTORS FOR MICROSCOPY**

(30) Priority: 29.12.2022 US 202263477579 P
(71) Applicant: FEI Company, Hillsboro, OR 97124-5793 (US)
(72) Inventor: MELE, Luigi, Eindhoven (NL); ANNE VAN VEEN, Gerard Nicolaas, Riethoven (NL); TIEMEIJER, Peter Christiaan, Eindhoven (NL)
(74) Representative: Boult Wade Tennant LLP

(57) **Abstract**

Improved detectors for microscopy are described herein. In one aspect, an apparatus can include: a plurality of electronic units arranged in an array; a plurality of pixels, each pixel of the plurality of pixels coupled to an associated electronic unit of the plurality of electronic units, wherein a first subset of pixels of the plurality of pixels is formed from a first material, and wherein a second subset of pixels of the plurality of pixels is formed from a second material, the first material being different than the first material, and a plurality of electrical connections disposed between the plurality of electronic units and the plurality of pixels, where each electrical connection connects respective electronic units with an associated pixel.

## Description

### TECHNICAL FIELD

The disclosed technology relates to the fields of detectors for charged particle microscopy systems.

### BACKGROUND

Detectors for charged particle microscopy typically include a sensing layer comprised of a plurality of sensing pixels, where charged particles originating from a charged particle generator interact with a sample, and subsequently contact the sensing layer; and an electronic layer comprised of a plurality of electronic units that receive an electronic signal originating with the charged particles and is transported via the sensing layer. The electronic layer can be more time- and cost-intensive to reconfigure compared to the sensing layer, such that reconfiguring a detector for a particular use case can be hindered due to the costs involved with reconfiguring the electronic layer.

Charged particle microscopy detectors also face inherent limitations on the compositions and sizes included in the sensing layer. Typically, the composition of the sensing layer is chosen for a particular energy range the detector is expected to collect (e.g., which can be dependent on the particular sample of the microscopy system). For example, a silicon (Si) composition for the sensing layer can be utilized for collecting charged particle with energy levels below 100 keV. The Si composition, however, may produce relatively less favorable results when collecting charged particles above 200 keV. Further, the sensing layer is typically sized to better capture charged particles of a given energy range. For example, a composition (e.g., Si) can be more effective for capturing a charged particle energy range (e.g., less than 100 keV) at particular set of dimensions (e.g., 50 µm width), than compared to another set of dimensions (e.g., 150 µm width) of the same composition.

These compositions and dimensions variations can create issues with detector selections. For example, typically, a microscopy system incorporates a single detector, which is limited to a single sensor configuration. This situation forces users to rely on a single sensor configuration for the entire range of energy levels. Some microscopy systems allow for two detectors, that are individually retractable. However, this inclusion of multiple detectors can be unduly expensive. Accordingly, there is a long-felt need in the field for improved charged particle microscopy detectors.

### SUMMARY

Improved charged particle microscopy detectors are described herein. In one aspect, a detector for charged particle microscopy can include a sensing layer and a detection layer. The sensing layer can include dimensions different from the electronic unit. For example, the sensing layer can include a larger width, or a larger length, or both, compared to the width and/or length of the respective electronic unit. This change of dimensions at the sensing layer can reconfigure the detector for particular uses. For example, a detector can include an aggregation of electronic units and sensing layers (e.g., a 384 x 128 aggregated ASIC and corresponding sensing pixels, with three 128 x 128 sensors positioned side-by-side). Although a traditional format for the detector is for the sensing layer dimensions to match the electronic unit dimensions (e.g., a 384 x 128 ASIC and 384 x 128 sensing pixels), by reconfiguring the dimensions of the sensing layer, the format for the detector can change (e.g., 1152 x 42 sensing pixels). This can be beneficial for particular uses for the detector, such as for direct electron (DE) detection, while maintaining the electronic unit whose dimensions can be ill-suited for the particular use case.

In another aspect, multiple compositions of the sensing layer can be implemented for the detector, which can utilize the different beneficial characteristics for each composition in the detector. In some cases, various rows of sensing layers can be of a different composition compared to other sensor rows of the detector. For example, different sensing layer compositions can be more effective at capturing charged particles within a given energy range compared to other compositions. By combining these different compositions on a particular detector, the detector can be implemented to more effectively capture charged particles of various energy ranges compared to a single composition sensing layer.

Further, the sensing layer and the electronic unit can be coupled to one another via an extension extending perpendicular to the planes defined by the sensing layer and the electronic unit. Thus, the sensing layer can be coupled to an electronic unit, even if a center point (or other coupling point) of the sensing layer is not adjacent to a center point (or other coupling point) of the electronic unit.
Further aspects of the present disclosure as set forth in the following numbered clauses:-
Clause 1. An apparatus comprising:
   a plurality of electronic units arranged in an array;
   a plurality of pixels, each pixel of the plurality of pixels coupled to an associated electronic unit of the plurality of electronic units;
   wherein each pixel of a first subset of pixels of the plurality of pixels defines a shape that is different than a shape of an associated electronic unit; and
   a plurality of electrical connections disposed between the plurality of electronic units and the plurality of pixels, wherein each electrical connection connects a respective electronic unit with an associated pixel.
Clause 2. The apparatus of clause 1, wherein the shape of the first subset of pixels comprises a rectangle, and the shape of the associated electronic unit comprises a square.
Clause 3. The apparatus of clause 1, wherein the first subset of pixels is a first material and a second subset of pixels is a second material that is different than the first material.
Clause 4. The apparatus of clause 3, wherein the first material is silicon (Si), and the second material is cadmium telluride (CdTe).
Clause 5. The apparatus of clause 1, wherein each pixel of the first subset of pixels has a different size than its associated electronic unit.
Clause 6. The apparatus of clause 1, wherein each pixel of the first subset of pixels extends across multiple electronic units in at least one direction.
Clause 7. The apparatus of clause 1, wherein the first subset of pixels is configured to convert a charged particle of a first energy level range to an electronic signal; and wherein a second subset of pixels of the plurality of pixels is configured to convert a charged particle of a second energy level range to an electronic signal, wherein the first energy level range and the second energy level range are different.
Clause 8. An apparatus comprising:
   a plurality of electronic units arranged in an array;
   a plurality of pixels, each pixel of the plurality of pixels coupled to an associated electronic unit of the plurality of electronic units;
   wherein each pixel of a first subset of pixels of the plurality of pixels defines a shape that is different than a shape of the associated electronic units;
   wherein the first subset of pixels of the plurality of pixels is formed from a first material, and wherein a second subset of pixels of the plurality of pixels is formed from a second material, the second material being different than the first material; and
   a plurality of electrical connections disposed between the plurality of electronic units and the plurality of pixels, where each electrical connection connects a respective electronic unit with an associated pixel.
Clause 9. The apparatus of clause 8, wherein the first material is silicon (Si), and the second material is cadmium telluride (CdTe).
Clause 10. The apparatus of clause 8, wherein at least one of the first material and the second material is formed from stacking a plurality of layers.
Clause 11. The apparatus of clause 8, wherein the shape of each pixel of the first subset of pixels is different than a shape defined by each pixel of the second subset of pixels.
Clause 12. The apparatus of clause 8, wherein each pixel of the first subset of pixels has a different size than their associated electronic unit.
Clause 13. The apparatus of clause 8, wherein each pixel of the first subset of pixels extends across multiple electronic units in at least one direction.

### BRIEF DESCRIPTION OF THE DRAWINGS

For the purpose of illustrating the invention, there is shown in the drawings a form that is presently preferred; it being understood, however, that this invention is not limited to the precise arrangements and instrumentalities shown.
FIG. 1 depicts a microscopy system that can incorporate detectors of the present disclosure.
FIG. 2 depicts a cross section of a detector for microscopy.
FIG. 3 depicts a cross section of a detector incorporating an extension according to the present disclosure.
FIGS. 4A and 4B depict top perspective views of a detector according to the present disclosure.
FIG. 5 depicts a top perspective view of a detector.
FIG. 6 depicts a top perspective view of a detector according to the present disclosure.
FIG. 7 depicts a top perspective view of a detector according to the present disclosure.
FIG. 8 depicts interaction volume graphs for various compositions.
FIG. 9 depicts a graph for exemplary, non-limiting MTF and DQE(0) values for various compositions.
FIG. 10 depicts interaction volume graphs for various compositions.
FIG. 11 depicts a top perspective view of a detector.
FIGS. 12-16 depict a detector with various numbers of sensing pixels incorporated onto an electronic layer, according to the present disclosure.
FIG. 17 depicts a sensor array according to the present disclosure.
FIG. 18 depicts a sensor array according to the present disclosure.

### DETAILED DESCRIPTION OF ILLUSTRATIVE EMBODIMENTS

The present disclosure may be understood more readily by reference to the following detailed description taken in connection with the accompanying figures and examples, which form a part of this disclosure. It is to be understood that this invention is not limited to the specific devices, methods, applications, conditions or parameters described and/or shown herein, and that the terminology used herein is for the purpose of describing particular embodiments by way of example only and is not intended to be limiting of the claimed invention. Also, as used in the specification including the appended claims, the singular forms "a," "an," and "the" include the plural, and reference to a particular numerical value includes at least that particular value, unless the context clearly dictates otherwise. The term "plurality", as used herein, means more than one. When a range of values is expressed, another embodiment includes from the one particular value and/or to the other particular value. Similarly, when values are expressed as approximations, by use of the antecedent "about," it will be understood that the particular value forms another embodiment. All ranges are inclusive and combinable, and it should be understood that steps can be performed in any order. Any documents cited herein are incorporated by reference in their entireties for any and all purposes.

It is to be appreciated that certain features of the invention which are, for clarity, described herein in the context of separate embodiments, can also be provided in combination in a single embodiment. Conversely, various features of the invention that are, for brevity, described in the context of a single embodiment, can also be provided separately or in any subcombination. Further, reference to values stated in ranges include each and every value within that range. In addition, the term "comprising" should be understood as having its standard, open-ended meaning, but also as encompassing "consisting" as well. For example, a device that comprises Part A and Part B can include parts in addition to Part A and Part B, but can also be formed only from Part A and Part B.

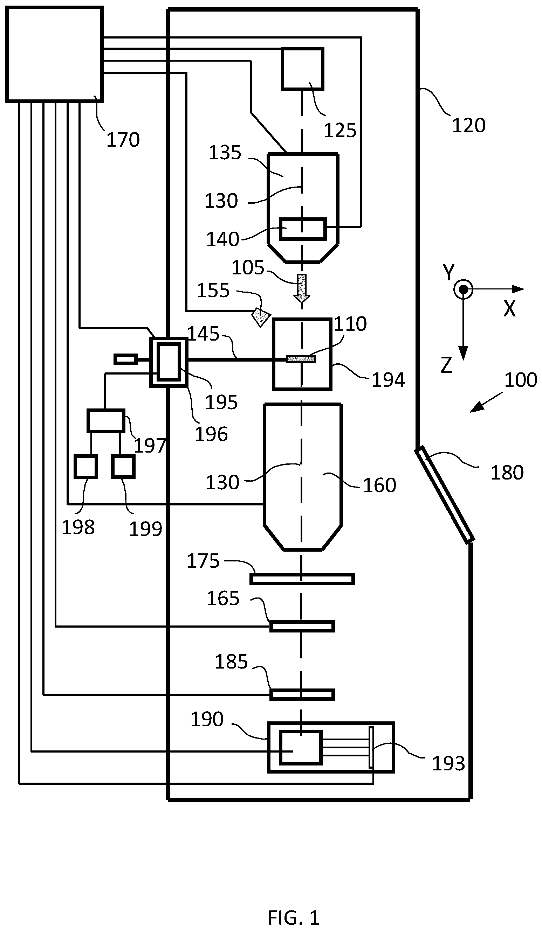

Turning to FIG. 1, FIG. 1 depicts a microscopy system 100, particularly a transmission electron microscopy (TEM) system 100 configured to use an electron beam 105 to observe and/or characterize a sample 110. Microscopy system 100 can acquire an image of the sample 110 using the emissions in the transmission region of the microscopy system 100. Thus, system 100 can represent a Transmission Electron Microscope (TEM) or a Scanning Transmission Electron Microscope (STEM).

Within a vacuum enclosure 120, an electron source 125 can produce the beam 105 of electrons that propagates along an electron-optical axis 130 and traverses an electron-optical illuminator 135, serving to direct/focus the electrons onto a chosen part of the sample 110 positioned in sample chamber 194. Sample 110 can be, e.g., be (locally) thinned/planarized or otherwise processed for analysis.

Also depicted is a deflector 140, which can, inter alia, be used to effect scanning motion of the beam 105. The sample 110 can be held on a sample holder 145 that can be positioned in multiple degrees of freedom by a goniometer 196. For example, the sample 110 can be positioned in a holder capsule of the sample holder that can be moved (inter alia) in the XY plane (see the depicted Cartesian coordinate system; typically, motion parallel to Z and tilt about X/Y will also be possible). Such movement allows different parts of the sample 110 to be illuminated / imaged / inspected by the electron beam 105 traveling along axis 130 (in the Z direction) (and/or allows scanning motion to be performed, as an alternative to beam scanning). If desired, an optional cooling device (not depicted) can be brought into intimate thermal contact with the sample holder 145, so as to maintain it (and the sample 110 thereupon) at cryogenic temperatures, for example. The holder capsule of the sample holder can be sealable, so that the sample can be transferred into and out of the TEM under vacuum or inert gas.

The electron beam 105 can interact with the sample 110 in such a manner as to cause various types of "stimulated" radiation to emanate from the sample 110, including (for example) secondary electrons, backscattered electrons, X-rays and optical radiation (cathodoluminescence). If desired, one or more of these radiation types can be detected with the aid of analysis device 155, which might be a combined scintillator/photomultiplier or EDX (Energy-Dispersive X-Ray Spectroscopy) module. However, alternatively or supplementally, one can study electrons that traverse (pass through) the sample 110, exit/emanate from the sample 110, and continue to propagate (substantially, though generally with some deflection/scattering) along axis 130.

Such a transmitted electron flux enters an imaging system (projection lens) 160, which can comprise a variety of electrostatic / magnetic lenses, deflectors, correctors (such as stigmators), and the like. In normal (non-scanning) TEM mode, this imaging system 160 can focus the transmitted electron flux. Various types of analysis apparatus can be used downstream of imaging system 160, such as a TEM camera 165. At camera 165, the electron flux can form a static image (or diffractogram) that can be processed by controller/processor 170 and displayed on a display device (not depicted), such as a flat panel display, for example. When not required, camera 165 can be retracted/withdrawn so as to get it out of the way of axis 130. Alternatively, or additionally, the imaging system 160 can be used to focus the transmitted electron flux onto a fluorescent screen 175, which, if desired, can be retracted/withdrawn so as to get it out of the way of axis 130. An image (or diffractogram) of (part of) the sample 110 will be formed by imaging system 160 on screen 175, and this can be viewed through viewing port 180.

An analysis apparatus can also include a STEM camera 185. An output from camera 185 can be recorded as a function of (X,Y) scanning position of the beam 105 on the sample 110, and an image can be constructed that is a "map" of output from camera 185 as a function of X,Y. Camera 185 can include a single pixel with a diameter of e.g. 20 mm, as opposed to the matrix of pixels characteristically present in camera 165. Moreover, camera 185 will generally have a much higher acquisition rate (e.g., 10⁶ points per second) than camera 165 (e.g., 10² - 10³ images per second). Once again, when not required, camera 185 can be retracted/withdrawn so as to get it out of the way of axis 130.

As an alternative to imaging using cameras 165 or 185, one can also invoke spectroscopic apparatus 190, which could be an Electron Energy Loss Spectroscopy (EELS) module, for example. The apparatus 190 can include a detector 193, which can be an EELS sensor array. A sensor array can include a sensing layer and an electronic layer, which is described in more detail below. It should be noted that the order/location of items 165, 185, and 190 is not strict, and many possible variations are conceivable. For example, spectroscopic apparatus 190 can also be integrated into the imaging system 160.

The controller 170 is connected to various illustrated components via control lines (buses). The controller includes at least a processor as well as a non-transitory memory for storing computer readable instructions. By executing the computer readable instructions in the processor, this controller 170 can provide a variety of functions, such as synchronizing actions, providing setpoints, processing signals, performing calculations, and displaying messages/information on a display device (not depicted). The controller can be configured to implement some or all steps of the methods described herein. The controller 170 can be (partially) inside or outside the enclosure 120, and can have a unitary or composite structure, as desired.

The goniometer 196 can position the sample under the electron beam within a vacuum chamber of the microscope. The vacuum chamber can be a sample chamber 194. The sample can be imaged or processed with the charged particle beams in the sample chamber. The goniometer 196 can be coupled with enclosure 120. The goniometer can include one or more actuation mechanisms for tilting the sample around one or more tilt axes.

The goniometer 196 includes a load lock 195 to facilitate the transfer of sample 110 from external to the microscopy system 100 to within the sample chamber. The load lock 195 can include ingress/egress points for the sample 110 to transition from the external of the TEM to the load lock 195, and from the load lock 195 to the sample chamber of the microscope column. For example, the load lock 195 can include an opening at one end for receiving a sample holder from the external of TEM. The load lock can be sealable from the external environment via one or more O-rings. Similarly, the load lock 195 can also include an opening on another end (e.g. opposite end) for passing the sample held by the sample holder from the load lock 195 to the sample chamber of the microscope. The opening between the load lock and the sample chamber is sealable via a valve. Thus, when the sample 110 is positioned within the load lock 195 (via the sample holder), the environment of load lock can be substantially isolated from sample chamber.

The goniometer 196 can include a gas delivery train 197 to place the chamber into interruptible fluid communication with both a protecting source 198 and with a vacuum pump 199. The load lock 195 can be coupled with one or more gas sources and pumps via valves for controlling the gas flow into and out of the load lock 195. In one example, the load lock can be fluidically connected to a vacuum pump 199 via a first valve and fluidically connected to a protecting gas source 198 via a second valve. The valves can be open or closed by actuation respective actuators controlled by the controller 170.

Any or all of the sensors discussed with regards to FIG. 1, such as TEM camera 165, STEM camera 185, and/or detector 193, may be formed from a sensing layer electrically coupled to a readout/control layer via respective contacts. In such examples, the sensing layer may have a plurality of pixels coupled to respective electronics in the readout/control layer. Such electrical connection(s) can connect pixels having a different shape and/or orientation than the associated electronics. In some examples, the pixels may extend across multiple areas of un-associated electronics. Additionally, some examples may have different sensors formed from different materials, where the different materials are tuned to different electron energies.

The TEM system can include other type of transmission electron microscopy system such as a scanning transmission electron microscope. In some examples, the TEM system can include another charged particle column such as an ion column.

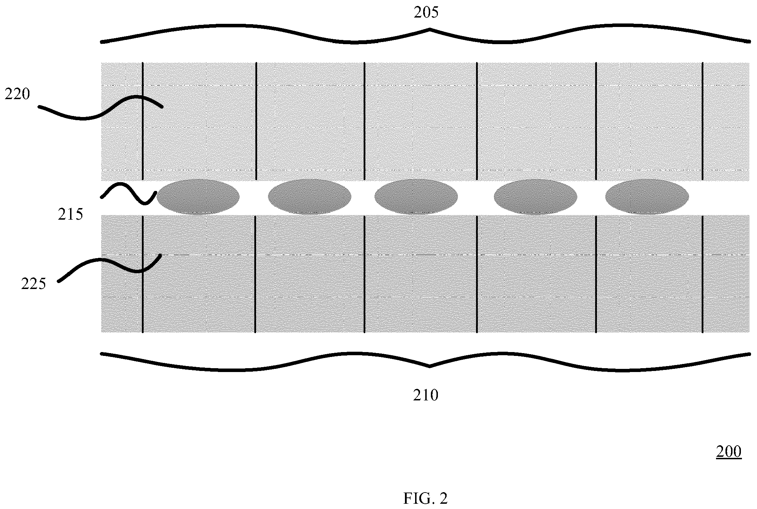

FIG. 2 depicts a cross-sectional view of a sensor 200 that can be implemented in a charged particle microscopy system, such as microscopy system 100 of FIG. 1 (e.g., detector 193). The sensor 200 can include a sensing layer 205 and an electronic layer 210. The sensing layer 205 can include a plurality of sensing pixels 220, which can be oriented in a plane. The electronic layer 210 can include a plurality electronic units 225, which can be oriented in a plane parallel to the plane of the sensing layer 205. The planes of the sensing layer 205 and the electronic layer 210 can define width and length directions.

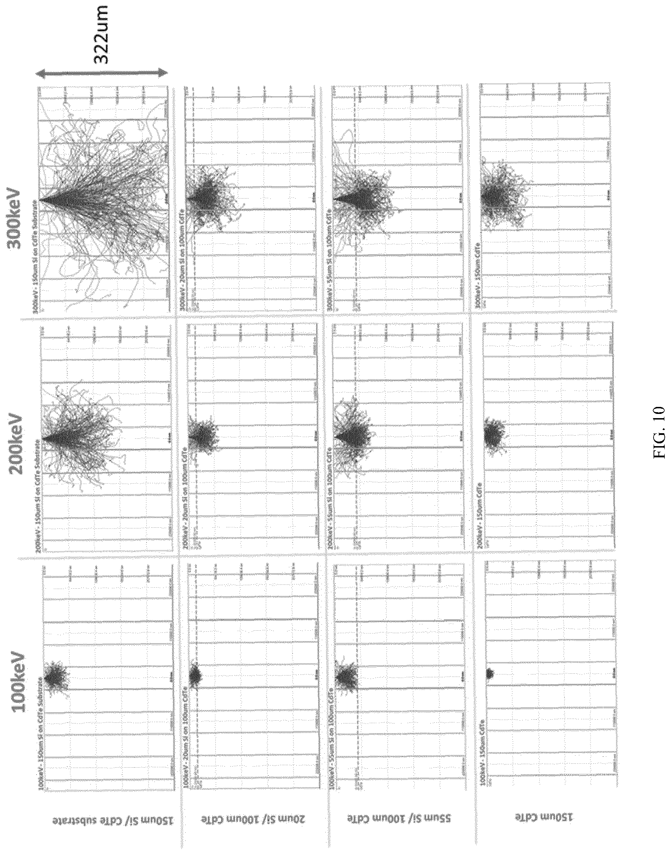

The sensor layer 205 can include a composition capable of transporting captured charged particles through the thickness of the sensing pixel 220. For example, compositions can include silicon (Si), cadmium telluride (CdTe), cadmium zinc telluride (CdZnTe), and gallium arsenide (GaAs). A given composition can be more effective at transporting captured charged particles based on a particular energy range of the charged particles. For example, FIG. 10 depicts interaction volume graphs for various compositions. The graphs depict emission interactions, such as electron emissions from the TEM, with various substrates. The first row of graphs depicts interaction volumes for 150 µm Si layered on a CdTe substrate. The second row of graphs depicts interaction volumes for 20 µm Si and 100 µm of CdTe. The third row of graphs depicts interactions volumes for 55 µm Si layered on 100 µm of CdTe. The fourth row of graphs depicts interactions volumes for 150 µm of CdTe.

The electronic layer 210 can include electronics capable of receiving an electronic signal from the sensing layer 205, and to relay the electronic signal to other electronic components to the microscopy system, such as a processor or memory of the microscopy system. For example, each electronic unit 225 can include a readout cell that is electrically coupled to one of the sensing pixels 220. While the sensing layer 205 and electronic layer 210 can provide for a 1:1 ratio between respective sensing pixels 220 and electronic units 225 (e.g., where each sensing pixel 220 is electrically coupled to a respective electronic unit 225, or where each sensing pixel profile is equivalent to, and centered on, a respective electronic unit profile), the disclosure provided herein can allow for differences in profiles between a sensing pixel and respective electronic unit, an offset between sensing pixel profile and respective electronic unit profile, and the like, which will be discussed in more detail below.

In some cases, the electronic layer 210 can form an application-specific integrated circuit (ASIC), or can be a part of an ASIC. The electronic layer 210 can define a plane along a width and length dimension of the layer., such that the plane of the electronic layer 210 is substantially parallel to the plane defined by the sensing layer 205.

The sensor 200 can also include a bump bonds 215. The bump bond can provide an electrical contact between the sensing layer 205 and the electronic layer 210. The bump bond 215 can be composed of a composition having high electrical conductivity, such as a metal. Typically, a bump bond contacts a center portion of a sensing pixel 220 and a center portion of an associated electronic unit 225, though this is not a requirement.

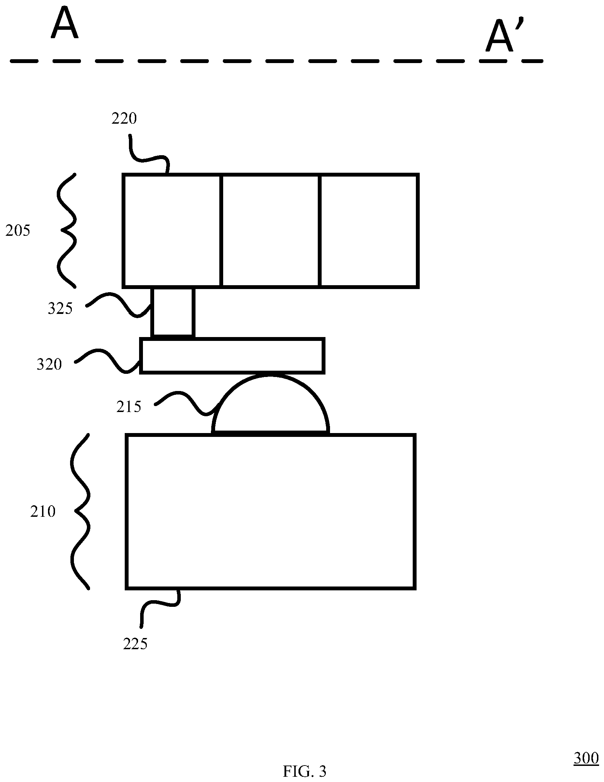

FIG. 3 depicts a cross-sectional view of a sensor 300 according to the present disclosure. The sensor can be implemented in a microscopy system, such as microscopy system 100 of FIG. 1. The sensor 300 includes a sensing layer 205 having one or more sensing pixels 220, an electronic layer 210 having one or more electronic units 225, a bump bond 215, and may further include an extension 320. The extension 320 can extend parallel to the planes defined by the sensing layer 205 and the electronic layer 210. In general, the extension 320 provides an electrical path that couples the bump bond 215 to the sensing pixel 220 that allows the sensing pixel 220 and the electronic unit 225 to be offset from one another in one or more dimensions. Additionally, extension 320 also allows for a shape and size of a sensing pixel 220 to be different than a shape and size of the associated electronic unit 225. In some examples, a member 325 can connect sensing pixel 220 to extension 320. The extension 320 and member 325 can also be composed of an electrically conductive material, such as a metal. The extension 320, through member 325, can couple the sensing pixel 220 with the electronic unit 225 (via the bump bond 215) when their respective geometries and locations are not similar. For example, where the center portion of the sensing pixel 220 and the center portion of the electronic unit 225 are adjacent to each other (e.g., along the center axis), the extension 320 can couple a region apart from the center portion of the sensing pixel 220 with the center portion of the electronic unit 225. In cases where the sensing pixel 220 does not align with the electronic unit 225 (e.g., along the center axis), the extension 320 can allow for the center portion of the sensing pixel 220 to be coupled to the center portion of the electronic unit 225.

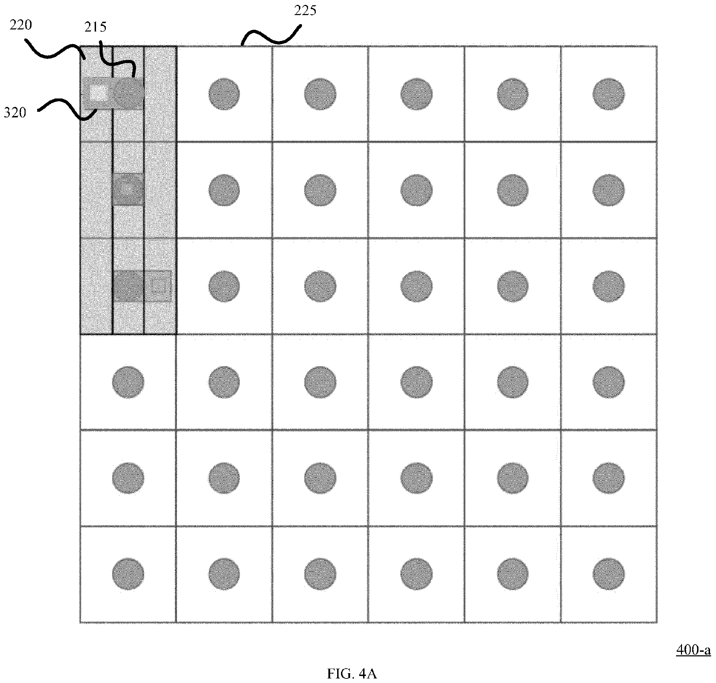

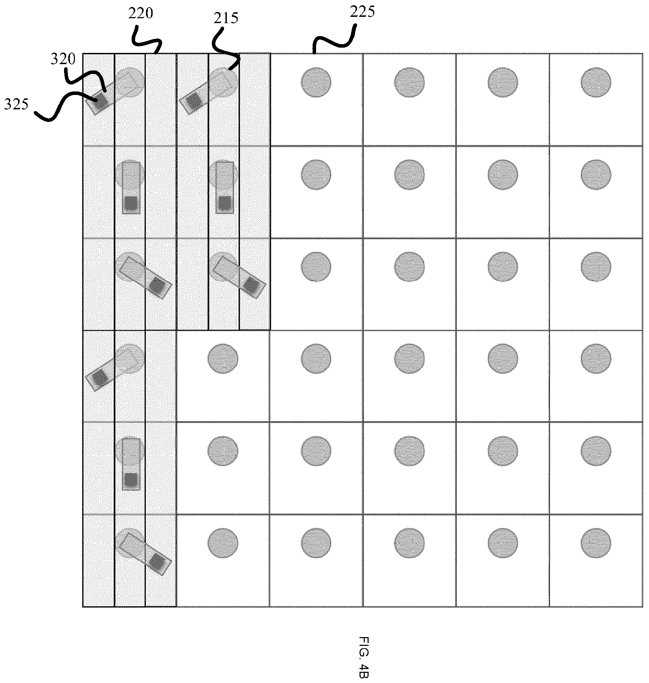

FIG. 4A and 4B depicts a detector 400-a, 400-b that can be implemented in a charged particle microscopy system, such as microscopy system 100 of FIG. 1 (e.g., detector 193). The detector 400-a, 400-b can include a plurality of electronic units 225, and a configuration of sensing pixels 220 coupled to electronic units 225 via bump bonds 215, extensions 320, and members 325. As shown in FIG. 4A and 4B, a sensing pixel (220) can be elongate in configuration, as opposed to a square pixel. In this way, the disclosed technology allows one to construct a device in which a pixel need not be the same size/shape as an associated electronic unit, which capability allows a user to utilize differently-shaped pixels depending on the user's needs. While FIG. 4A and 4B show three sensing pixels extending across three electronic units, such number and relationship is not limiting. For example, in some examples, 4 or more pixels may extend across 4 or more electronic units with similar connections as shown where a size of the sensors in one direction is reduced to accommodate the additional sensing pixels. Likewise, the angle and direction in which the extension 320 extends from the bump bond 215 can vary as well. For example, FIG. 4A depicts extensions 320 extending away from a corresponding bump bond 215 such that a length of the extension 320 is aligned with a width or length dimension of the detector 400-a. As another example, FIG. 4B depicts some extensions 320 extending away from a corresponding bump bond 215 offset from either the length or width dimensions of the detector 400-b (e.g., 45 degrees from the detector width/length dimension).

As mentioned, sensing pixels for the sensors described herein can be of different shapes, sizes, and the like, compared to the corresponding electronic unit to which the sensing pixel is electrically coupled to. For example, an electronic unit can be generally square in shape. A corresponding sensing pixel coupled to the electronic unit can be rectangular in shape (as depicted in FIG. 4A, 4B). However, the shape of the sensing pixel can be a variety of shapes. For example, the sensing pixel can be a square, a rectangle, a circle or oval, a polygon, an ellipse, a crescent, a polyomino, and the like. Likewise, the shape of the corresponding electronic unit can vary as well, and is not limited to the square shapes depicted in FIG. 4A, 4B.

In some cases, the dimensions of the sensing pixel can differ from that of the corresponding electronic unit. For example, a sensing pixel can define length and width dimensions, which can form a profile of the sensing pixel. Likewise, the corresponding electronic unit can define length and width dimensions, which can form a profile of the electronic unit. In some cases, the profile of the sensing pixel can differ from that of the corresponding electronic unit. For example the length or width, or both, of the sensing pixel can be different than the length or width of the corresponding electronic unit. Thus, in some cases, the sensing pixel can include a shape similar to that of the electronic unit; however, the size of the sensing pixel can be different than the corresponding electronic unit (due to the differences in dimensions). In some cases, the area of the sensing pixel can be equivalent to the area defined by the corresponding electronic unit. In some other cases, the area of the sensing pixel can differ than the area defined by the corresponding electronic unit.

In some cases, the profile of a sensing pixel can be offset from the profile of the corresponding electronic unit. For example, a sensing pixel can be oriented such that a profile does not entirely match the profile of the corresponding electronic unit. For example, when viewed in the thickness direction (such as in FIG. 4A, 4B), the profile of a sensing pixel does not entirely cover the profile of the corresponding electronic unit, or that a portion of the profile of the sensing pixel does not overlap with the profile of the corresponding electronic unit in the thickness direction (or vice versa). In some cases, edges or corners of a sensing pixel can be non-adjacent to respective edges or corners of a corresponding electronic unit when viewed in the thickness direction (e.g., a sensing pixel rotated 45 degrees with respect to the corresponding electronic unit).

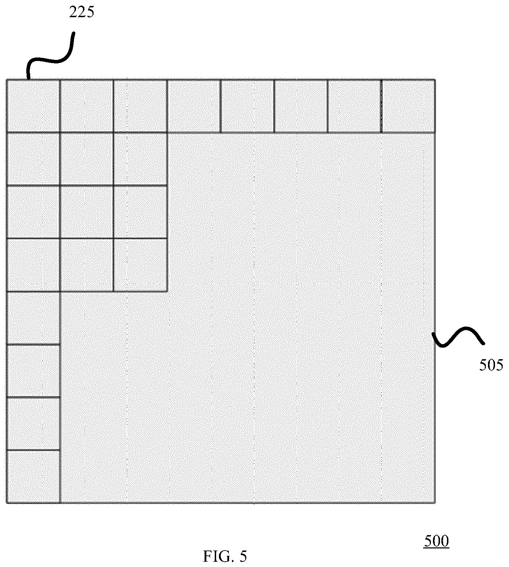

FIG. 5 depicts an electronic layer 500 for a sensor according to the present disclosure. FIG. 5 depicts a top view of the electronic layer 500 which can include a plurality of electronic units 225. The electronic units 225 can generally be 2-dimensional, such that the electronic unit 225 can define a length and width, and the thickness is substantially smaller than the length and width. The electronic units 225 can be arranged such that a side of an electronic unit can be adjacent to, or contact a side of another electronic unit. In this fashion, the electronic layer 500 can define a 2-dimensional plane. The electronic units 225 can be generally uniform in nature, such that a profile of an electronic unit can equate to other electronic units of the electronic layer 500. In some cases, the electronic units 225 can be dimensioned as a square. The electronic units 225 can be arranged such that the electronic units form the profile 505 outlined in FIG. 5.

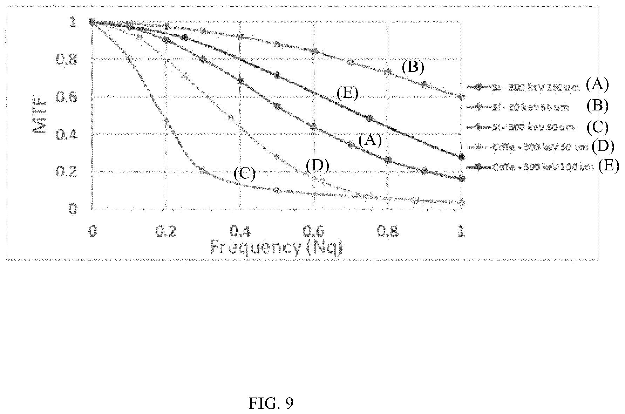

For electron energy loss spectroscopy (EELS), the dimensions and composition of the sensing layer can affect how well the sensing layer captures charged particles within a given energy range. For electron energies below 100 keV, Si with small dimensions (e.g., pixel size) can be effective (e.g., having high detective quantum efficiency (DQR) and modular transfer function (MTF) values). While CdTe and GaAs can also be used at small dimensions, those material systems can have lower DQE values with respect to Si. At electron energies greater than 200 keV, CdTe at smaller dimensions can be effective. Electron energies between 100 and 200 keV, Si having large dimensions can be effective (*See,* e.g., FIG. 9 for example MTF values for different sensing layer sizes and compositions). Further, Si can include DQE(0) values above 0.9. For GaAs, CdTe, and CdZnTe the DQE(0) can be between 0.6 and 0.8 at 300 keV, and between 0/4 and 0.7 at 100 keV. For MTF values, at pixel size of 50 µm, Si can be 0.1 at 100 keV, and 0.3 for CdTe at 100 keV.

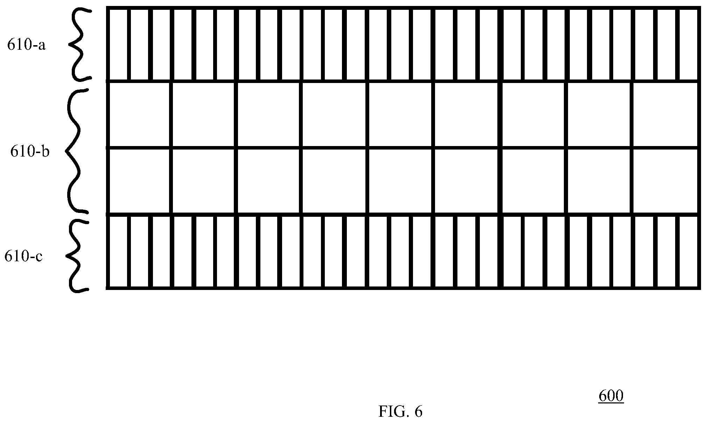

Thus, to capture charged particles across a wide range of energies, such as from 0 to 300 keV, different compositions and different dimensions of sensing pixels can be included in the sensing layer, while keeping conventional electronic unit dimensions of a corresponding electronic layer the same. FIG. 6 depicts a sensor array 600 for microscopy systems according to the present disclosure. The sensor array 600 can be a sensor, such as sensor 200 of FIG. 2. In some cases, the sensor array 600 can be an aggregation of sensors, such as three sensors 200 disposed side-by-side to form the sensor array. The sensor array 600 can include a sensing layer including a plurality of sensing pixels, and having sensing layer rows 610-a. 610-b, and 610-c. Row 610-a can include a first composition, row 610-b can include a second composition, and row 610-c can include a third composition. In some cases, the compositions can include Si, CdTe, or GaAs, respectively. In some cases, the dimensions for the sensing pixels of the rows 610-a-c can vary and need not be the same as the underlying electronic readout unit. For example, the width of a sensing pixel in row 610-a can be smaller than the width of a sensing pixel in row 610-b. Thus, for the width of the sensor array 600, there can be more sensing layers (e.g., pixels) in a given row (e.g., row 610-a) compared to another row (e.g., 610-b). The sensor array 600 can thus include different sensing pixel types, which can increase the effectiveness of the sensor array 600 in capturing charged particles across a wider range of energies.

The sensor array 600 can also include an electronic layer (not shown). The electronic layer can include a plurality of electronic units such as those described above with reference to FIG. 2, where for example, each electronic unit includes a chip readout for receiving electrical measurements from a corresponding sensing pixel. The dimensions of each electronic unit can be uniform throughout, such that an electronic unit corresponding to a sensing layer of row 610-a can include the same dimensions as an electronic unit corresponding to row 610-b. For example, the dimensions of an electronic unit can match the dimensions of a sensing pixel in row 610-b (e.g., such that a sensing pixel of row 610-b sits on top of the corresponding electronic unit, and a center portion of the sensing pixel is coupled to a center portion of the electronic unit). In cases where a sensing pixel is offset from the corresponding electronic unit, a bump bond and extension can electrically couple the layers.

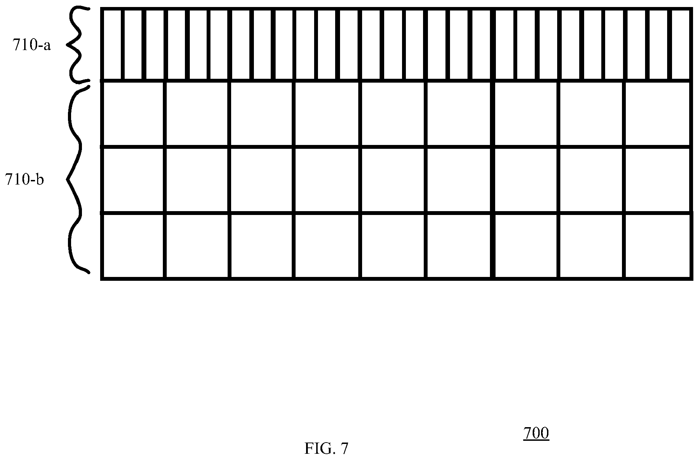

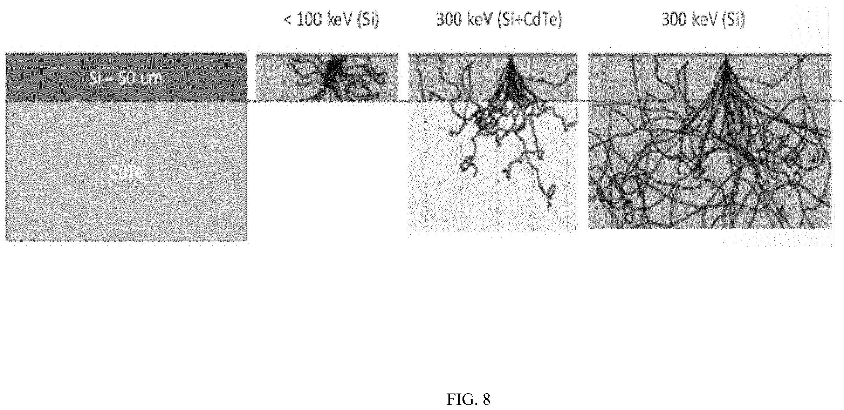

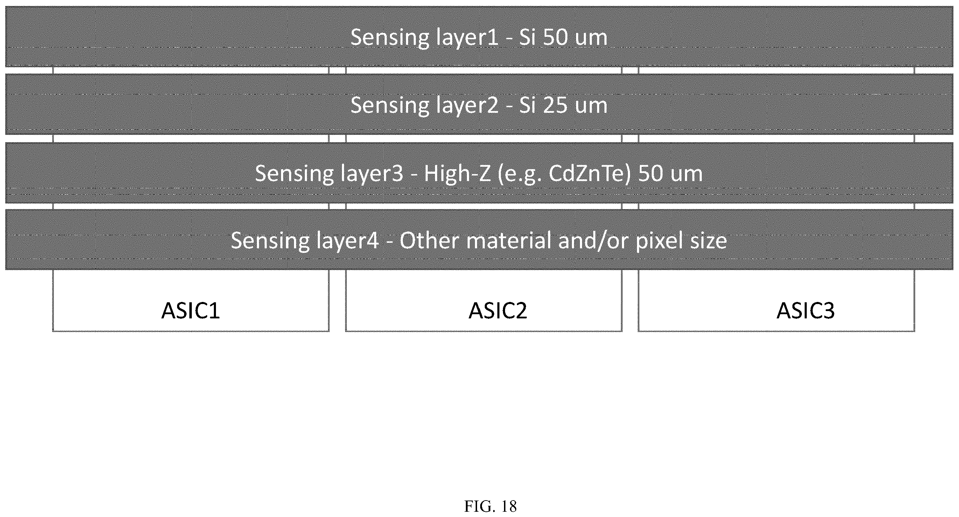

FIG. 7 depicts a sensor array 700 for microscopy according to the present disclosure. The sensor array 700 can include an aggregated sensing layer having sensing layer row 710-a and sensing layer rows 710-b. Row 710-a can include a first composition, and rows 710-b can include a second composition (e.g., Si). In some cases, the first composition can include layered compositions, such as Si layered on top of, or the bottom of, CdTe. This layered composition can utilize the benefits of the variety of compositions included therein. For example, a layered composition can include a 50 µm thick layer of Si positioned on top of a layer of CdTe. The Si can absorb energy below 100 keV, and the CdTe can reduce interaction volume for charged particles with energy between 200-300 keV. This layered composition can thus reduce backscattering, which can provide a higher DQE value compared to a layer of CdTe. FIG. 8 depicts interaction volumes for various sensing pixel configurations according to the present disclosure. FIG. 8 depicts a 50 µm layer of Si interacting with electron emissions having less than 100 keV of energy; a 50 µm layer of Si on top of a CdTE substrate interacting with electron emissions having 300 keV of energy; and a 50 µm layer of Si on top of a Si substrate interacting with electron emissions having 300 keV of energy. As shown in FIG. 8, the CdTe substrate composition reduces backscattering of electron emissions at 300 keV compared to the backscattering experienced by the Si-only pixel composition at 300 keV energy. An example of this layered sensor array can be found in FIG. 18, where a first sensing layer is layered on a second sensing layer, second layer is layered on a third sensing layer, third sensing layer is layered on fourth sensing layer, and fourth sensing layer is layered on an electronic unit layer (e.g., which can include a number of ASICs).

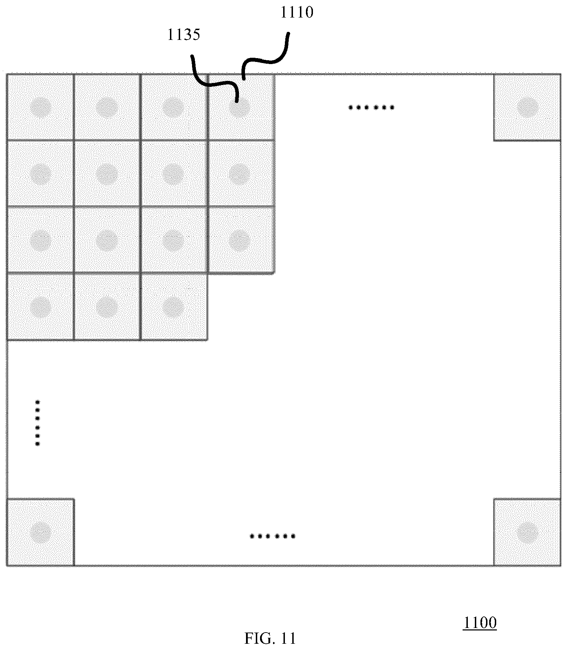

FIG. 11 depicts a top view of a sensor array 1100 for microscopy systems. FIG. 11 illustrates a contact region 1135 for each sensing pixel 1110, where each sensing pixel 1110 is electrically coupled to a corresponding electronic unit. In this configuration, the contact region 1135 can be adjacent to a contact region of a corresponding electronic unit (e.g., the contact region 1135 aligns with the contact region of the corresponding electronic unit positioned below the sensing pixel). In short, Fig. 11 shows a 1 to 1 relationship in terms of shape and size between the sensing pixels and associated electronic units.

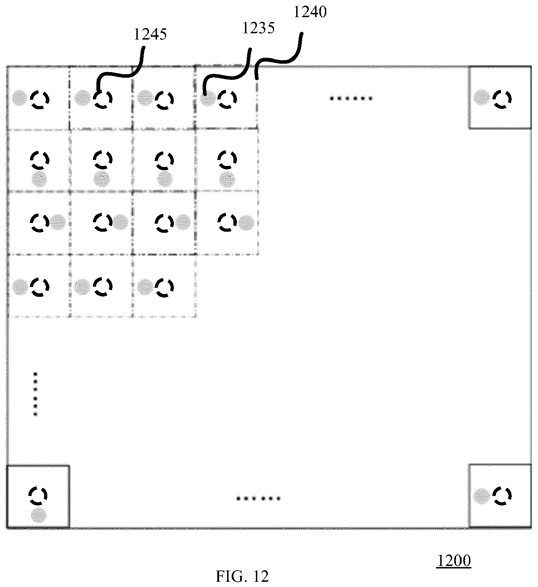

FIG. 12 depicts a top view of a sensor array 1200. FIG. 12 illustrates contact regions 1235 of a sensing layer of sensing pixels with respect to a corresponding electronic unit (as shown with dashed lines 1240). As can be seen, the contact regions 1235 do not align with a contact region of a corresponding electronic unit. Thus, in cases where the contact region of the sensing layer is electrically coupled to the contact region 1245 of the electronic unit, an extension (e.g., extension 320) can be utilized between the sensing layer and electronic unit.

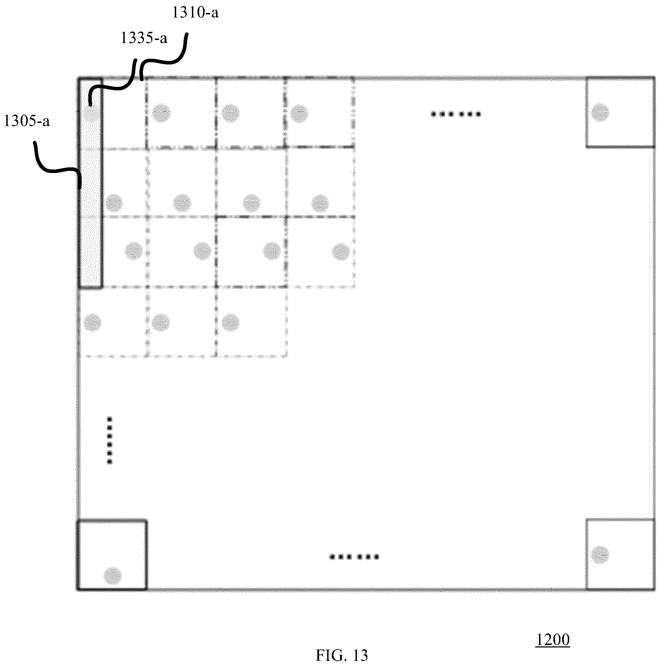

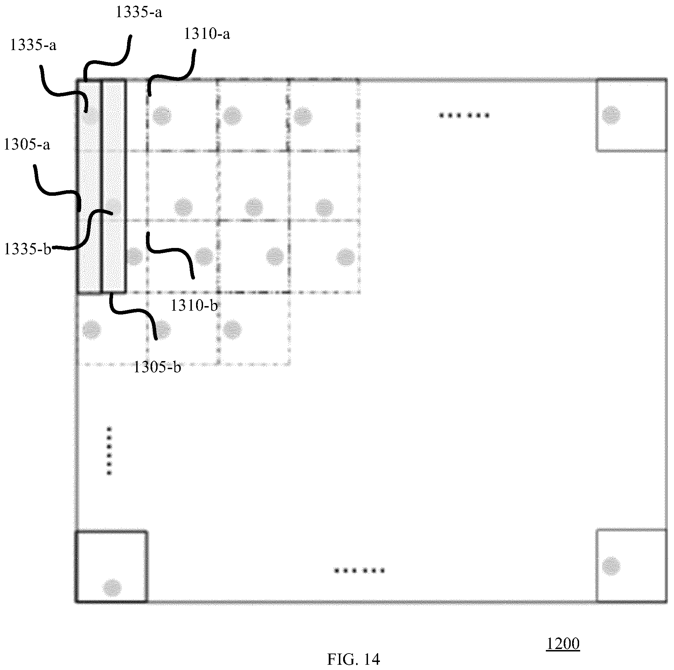

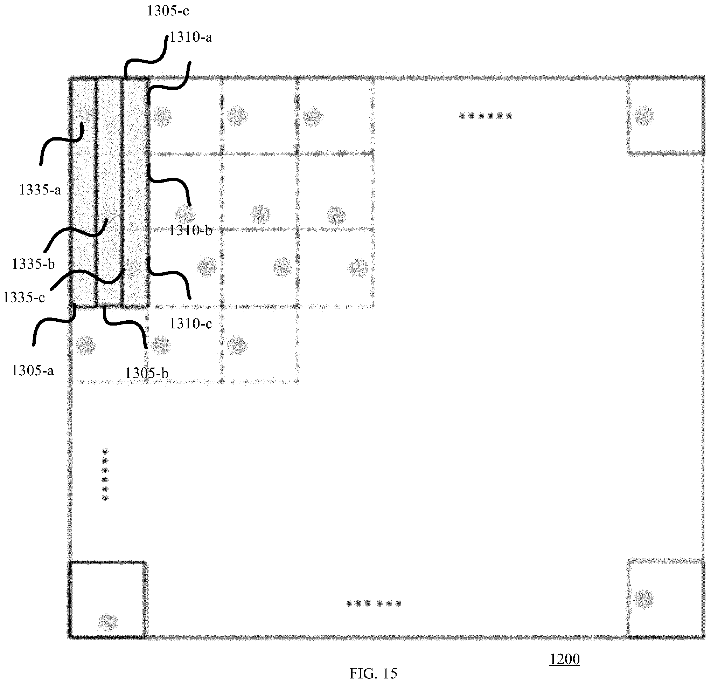

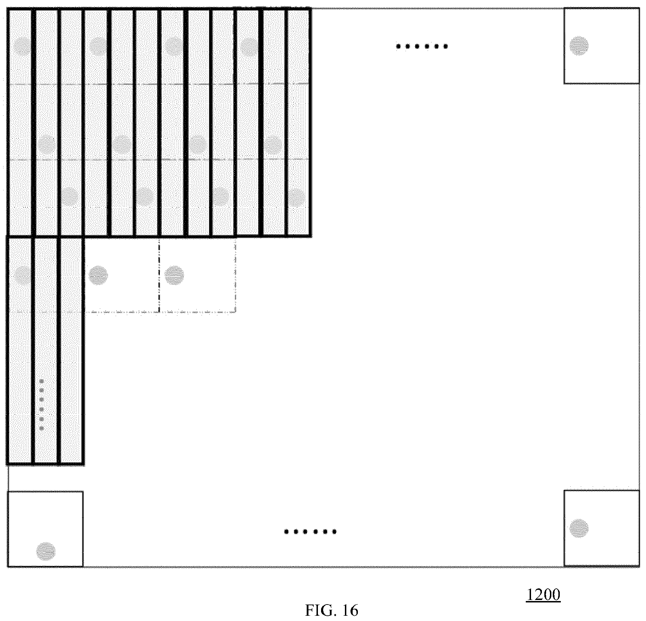

FIGS. 13-16 illustrate the sensor array 1200 with additional sensing pixels incorporated. For example, FIG. 13 illustrates a sensing pixel 1310-a positioned with respect to the electronic layer. The sensing pixel 1310-a can be coupled at contact region 1335-a, to electronic unit 1305-a. The contact region for the electronic unit 1310-a can be within a center area of the electronic unit 1310-a and thus the contact region 1335-a and the contact region for the electronic unit 1310-a are not aligned. Thus, an extension (e.g., extension 320 of FIG. 3) can electrically couple the sensing pixel 1305-a to the electronic unit 1310-a (e.g., via a bump bond) by extending between contacts of the pixel 1305-a and the electronic unit 1310-a. In some cases, a member (e.g., member 325 of FIG. 3) can also be utilized to couple the extension to the sensing pixel). As can be seen, the dimensions of the sensing pixel 1305-a can be different than the dimensions of the electronic unit 1310-a. For example, the sensing pixel 1305-a can be three times smaller in the width dimension compared to the width of the electronic unit 1310-a, whereas the sensing pixel 1305-a can be three times as large in the length dimension compared to the length of the electronic unit 1310-a. FIG. 14 illustrates a second sensing pixel 1305-b coupled to an electronic unit 1310-b, and FIG. 15 illustrates a third sensing layer 1305-c coupled to an electronic unit 1310-c. As can be seen, the contact region 1035-a-c for each sensing layer 1305-a-c can differ with respect to a contact region for a corresponding electronic unit 1310-a-c. For example, the positioning of the contact region 1335-a can be a 90 degree clockwise shifted with respect to the contact region 1335-b (with respect to the contact region of the corresponding electronic unit 1310-a and b). Thus, the positioning of the contact regions with respect to the corresponding electronic unit can form a pattern (e.g., 90 degree clockwise shifted, 90 degree counter-clockwise shifted, 180 degree shifted, and the like), along a given dimension of the sensor array 1200 (e.g., length or width). This pattern can be further seen in FIG. 15.

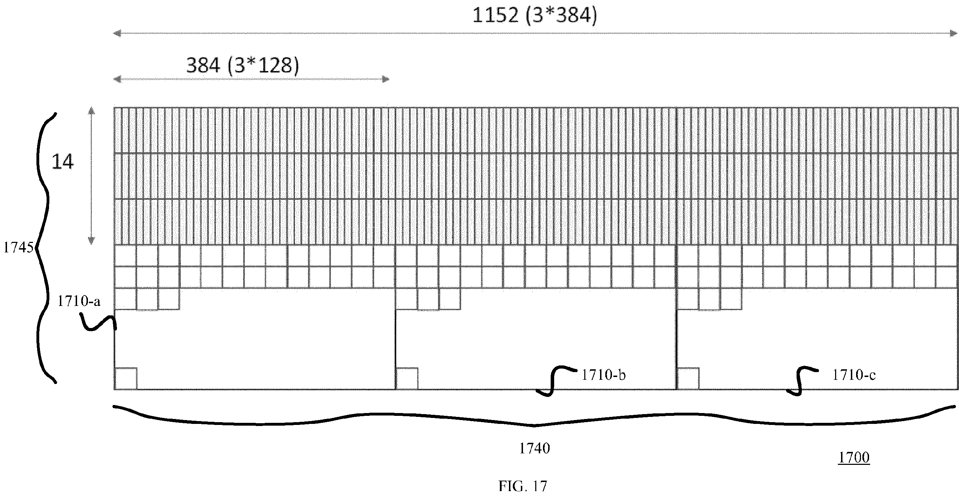

Thus sensing layers having different dimensions compared to their respective electronic units can be implemented. By altering the dimensions of the sensing layer (e.g., the sensing pixel shapes and sizes) with respect to the electronic unit, a number of sensing pixels along a given sensor array dimension can be increased or decreased. For example, FIG. 17 depicts a sensor array 1700 according to the present disclosure. The sensor array 1700 can include an electronic layer, which can include, for example, one or more ASICs (e.g., ASICS 1710-a-c). The electronic layer can include a number of electronic units along the width dimension, such as 384 electronic units, and a number of electronic units along the length dimension, such as 128 electronic units. The sensor array 1700 can also include an aggregated sensing layer, which can include a number of sensing pixels along the width dimension 1740, such as 1,152 sensing pixels, and a number of sensing pixels along the length dimension 1745, such as 14. The sensor array 1700 can thus be configured for particular EELS detections while maintaining an electronic layer that can be configured for different detections.

As a particular non-limiting example, an Electron Microscope Pixel Array Detector (EMPAD) can include a 150 µm electronic unit (e.g., ASIC) can be utilized, along with a differently dimensioned sensing pixel layer. The sensing pixel dimensions can be include 450 µm in length and 50 µm in width. Thus, on a 150 µm x 150 µm electronic unit, 384 sensing pixels can be positioned in the width dimension. By tiling 3 electronic units together (e.g., side by side), 1,152 pixels can be positioned in the width direction, and 14 pixels in the length direction. With a frame rate of 10,000 frames per second, this configuration can enable the capturing of 100,000 spectra per second.

### EXEMPLARY EMBODIMENTS

The following embodiments are exemplary only and do not serve to limit the scope of the present disclosure of the appended claims. It should be understood that any part of any one or more Embodiments can be combined with any part of any other one or more Embodiments.

### Embodiment 1

A sensor, comprising: an electronic layer configured to receive and send electronic signals, the electronic layer defining a first dimension measured along a first direction and a second dimension measured along a second direction; and a sensing layer coupled to the electronic layer, the sensing layer defining a first dimension measured along the first direction and a second dimension measured along the second direction, and (a) the first dimension of the electronic layer differing from the first dimension of the sensing layer, (b) the second dimension of the electronic layer differing from the second dimension of the sensing layer, or both (a) and (b).

### Embodiment 2

The sensor of Embodiment 1, wherein at least one of the first dimension and the second dimension comprises a length or a width.

### Embodiment 3

The sensor of any one of Embodiments 1 through 2, wherein the electronic layer comprises an ASIC.

### Embodiment 4

The sensor of any one of Embodiments 1 through 3, wherein the sensing layer is configured to: receive a charged particle, convert the charged particle to an electronic signal; and send the electronic signal to the electronic layer via a coupling between the electronic layer and the sensing layer.

### Embodiment 5

The sensor of any one of Embodiments 1 through 4, wherein a coupling between the sensing layer and the electronic layer comprises a bump bond, the coupling optionally comprising at least one via placing the bump bond in electronic communication with the sensing layer.

### Embodiment 6

The sensor of any one of Embodiments 1 through 5, wherein each of the sensing layer and the electronic layer define a center point, and wherein (a) a portion of the sensing layer other than the center point is coupled to the center point of the electronic layer or (b) a portion of the electronic layer other than the center point is coupled to the center point of the sensing layer.

### Embodiment 7

The sensor of any one of Embodiments 1 through 6, wherein the sensing layer and the electronic layer each define a plane, wherein each plane is parallel with the other.

### Embodiment 8

The sensor of any one of Embodiments 1 through 7, wherein a coupling between the electronic layer and the sensing layer comprises a portion that extends in parallel with the electronic layer plane and the sensing layer plane.

### Embodiment 9

The sensor of any one of Embodiments 1 through 8, wherein a perimeter profile of the sensing layer is different than a perimeter profile of the electronic layer.

### Embodiment 10

The sensor of any one of Embodiments 1 through 9, wherein the perimeter profile of the electronic layer comprises a square.

### Embodiment 11

The sensor of any one of Embodiments 1 through 10, wherein the perimeter of the sensing layer comprises a rectangle or a polyomino.

### Embodiment 12

The sensor of any one of Embodiments 1 through 11, wherein the sensor is configured for electron energy loss spectroscopy (EELS).

### Embodiment 13

The sensor of any one of Embodiments 1 through 12, wherein the electronic layer is 150µm x 150µm, and wherein the sensing layer has a width of 50 µm.

### Embodiment 14

A sensor array for spectroscopy, comprising: a plurality of the sensor of any of Embodiments 1-13, wherein the plurality of the sensing layers defines an aggregated sensing layer, and the plurality of the electronic layers defines an aggregated electronic layer, the sensor array defining a plane.

### Embodiment 15

A sensor array of Embodiment 14, wherein the aggregated electronic layer further comprises at least one electronic layer free of coupling to a sensing layer.

### Embodiment 16

A sensor array of any of Embodiments 14 through 15, wherein the aggregated sensing layer comprises 128 sensing layers arranged along a first direction in the plane of the aggregated sensing layer.

### Embodiment 17

A sensor array of any of Embodiments 14 through 16, wherein the aggregated sensing layer comprises at least two sensing layers arranged along a second direction in the plane of the aggregated sensing layer.

### Embodiment 18

A sensor array of any of Embodiments 14 through 17, wherein the plurality of couplings comprises a coupling pattern defining a plurality of coupling locations, and (i) wherein within the coupling pattern a first coupling of the plurality of couplings is coupled to a first sensing layer at a first location located at a first distance measured along a direction parallel to the plane, (ii) wherein a second coupling is coupled to a second sensing layer at a location located at a second distance measured along the direction, and (iii) wherein the first distance differs from the second distance.

### Embodiment 19

A sensor array of any of Embodiments 14 through 18, wherein a first coupler of the plurality of couplings extends in a first direction parallel to the plane, wherein a second coupler of the plurality of couplings extends in a second direction parallel to the plane, and wherein the first direction differs from the second direction.

### Embodiment 20

A sensor array of any of Embodiments 14 through 19, wherein the coupling locations of a plurality of the electronic layers are arranged in a substantially periodic manner.

### Embodiment 21

A sensor array, comprising: an electronic layer comprising a plurality of electronic units configured to receive and send electronic signals, the electronic layer optionally comprising an ASIC, the electronic layer defining a first dimension measured along a first direction and a second dimension measured along a second direction, wherein the electronic layer further defines a plurality of rows of the electronic units, and wherein each row of the plurality of rows optionally spans either the first dimension or the second dimension; a first sensing layer comprising a plurality of first sensing pixels composed of a first material, wherein a first sensing pixel is coupled to a respective electronic unit of the plurality of electronic units; and a second sensing layer comprising a plurality of second sensing pixels composed of a second material that differs from the first material, and wherein each of the second sensing pixels is coupled to a respective electronic unit of the plurality of electronic units.

### Embodiment 22

A sensor array of Embodiment 21, wherein a first sensing pixel or a second sensing pixel is composed of silicon (Si).

### Embodiment 23

A sensor array of any of Embodiments 21 through 22, wherein a first sensing pixel or a second sensing pixel is composed of cadmium telluride (CdTe) or gallium arsenide (GaAs).

### Embodiment 24

A sensor array of any of Embodiments 21 through 23, wherein a first subset of the plurality of rows is comprised of the first sensing layer, and wherein a second subset of the plurality of rows is comprised of the second sensing layer.

### Embodiment 25

A sensor array of any of Embodiments 21 through 24, wherein each of the first sensing pixels and the second sensing pixels are configured to: receive a charged particle, convert the charged particle to an electronic signal; and send the electronic signal to the electronic layer via a coupling between (i) a respective sensing pixel of either the plurality of first sensing pixels or of the plurality of second sensing pixels, and (ii) a corresponding electronic unit of the plurality of electronic units.

### Embodiment 26

A sensor array of any of Embodiments 21 through 25, wherein the first sensing layer is configured to convert a charged particle of a first energy level range to an electronic signal; and wherein the second sensing layer is configured to convert a charged particle of a second energy level range to an electronic signal, wherein the first energy level range and the second energy level range are different.

### Embodiment 27

A sensor array of any of Embodiments 21 through 26, wherein the first energy level range comprises less than 100 keV, between 100keV and 200 keV, and greater than 200 keV.

### Embodiment 28

A sensor array of any of Embodiments 21 through 27, wherein a first sensing pixel defines a different perimeter shape than a perimeter shape of a second sensing pixel.

### Embodiment 29

A sensor array of any of Embodiments 21 through 28, wherein the plurality of first sensing pixels defines a total number of first sensing pixels, wherein the plurality of second sensing pixels defines a total number of second sensing pixels, and wherein the first number differs from the second number.

### Embodiment 30

A sensor array of any of Embodiments 21 through 29, wherein each of a first sensing pixel of the plurality of first sensing pixels and each of an electronic unit of the plurality of electronic units define a third dimension measured along the first direction and a fourth dimension measured along the second direction, and (a) the third dimension of the electronic unit is the same as the third dimension of the first sensing pixel, (b) the third dimension of the electronic unit differs from the third dimension of the first sensing pixel, (c) the fourth dimension of the electronic unit is the same as the fourth dimension of the first sensing pixel (d) the fourth dimension of the electronic unit differs from the fourth dimension of the first sensing pixel, or a combination thereof.

### Embodiment 31

A sensor array of any of Embodiments 21 through 30, further comprising a third sensing layer composed of the first material, and comprising a plurality of third sensing pixels, wherein each of the third sensing pixels is coupled to a respective electronic unit; and wherein a perimeter profile shape of a first sensing pixel differs from a perimeter profile shape of a third sensing pixel.

### Embodiment 32

A sensor array of any of Embodiments 21 through 31, wherein the electronic layer lies in a plane and a line extending orthogonally from the plane passes through a first sensing pixel and through a second sensing pixel, and wherein the first sensing pixel is coupled to the second sensing pixel, the second sensing pixel being coupled to an electronic unit of the electronic layer.

### Embodiment 33

A sensor array of any of Embodiments 21 through 32, wherein the first sensing layer is configured to convert a charged particle of a first energy level range to an electronic signal; and wherein the third sensing layer is configured to convert a charged particle of a second energy level range to an electronic signal, wherein the first energy level range and the second energy level range are different.

### Embodiment 34

A sensor array of any of Embodiments 21 through 33, wherein the perimeter profile shape of each of the first sensing pixels is a rectangle, and wherein the perimeter profile shape of each of the third sensing layers is a square.

### Embodiment 35

A sensor array of any of Embodiments 21 through 34, wherein the sensor array is configured for electron energy loss spectroscopy (EELS).

### Embodiment 36

A sensor array of any of Embodiments 21 through 35, wherein the electronic layer lies in a plane and a first line extending orthogonally from the plane passes through a first sensing pixel without passing through a second sensing pixel, and wherein a second line extending orthogonally from the plane passes through a second sensing pixel without passing through a first sensing pixel.

### Embodiment 37

A sensor array of any of Embodiments 21 through 36, wherein a coupling between a respective first sensing pixel of the plurality of first sensing pixels, and a corresponding electronic unit of the plurality of electronic units comprises a bump bond, the coupling optionally comprising at least one via placing the bump bond in electronic communication with the first sensing layer.

### Embodiment 38

A sensor array of any of Embodiments 21 through 37, wherein each a first sensing pixel of the plurality of first sensing pixels and an electronic unit of the plurality of electronic units define a center point, and wherein (a) a portion of the first sensing pixel other than the center point is coupled to the center point of the electronic layer or (b) a portion of the electronic unit other than the center point is coupled to the center point of the first sensing pixel.

### Embodiment 39

A sensor array of any of Embodiments 21 through 38, wherein the first sensing layer and the second sensing layer define a first plane, and the electronic layer defines a second plane, wherein the first plane and the second plane are parallel with each other.

### Embodiment 40

A sensor array of any of Embodiments 21 through 39, wherein a coupling between a first sensing pixel and the corresponding electronic unit comprises a portion that extends in parallel with the first plane and the second plane.

### Embodiment 41

An apparatus comprising: a plurality of electronic units arranged in an array; a plurality of pixels, each pixel of the plurality of pixels coupled to an associated electronic unit of the plurality of electronic units, wherein a first subset of pixels of the plurality of pixels is formed from a first material, and wherein a second subset of pixels of the plurality of pixels is formed from a second material, the first material being different than the first material, and a plurality of electrical connections disposed between the plurality of electronic units and the plurality of pixels, where each electrical connection connects its respective electronic units with an associated pixel.

### Embodiment 42

The apparatus of Embodiment 41, wherein the first material is silicon (Si), and the second material is cadmium telluride (CdTe).

### Embodiment 43

The apparatus of any of Embodiments 41 through 42, wherein at least one of the first material and the second material is formed from stacking a plurality of layers.

### Embodiment 44

The apparatus of any of Embodiments 41 through 43, wherein each pixel of the first subset of pixels has a different shape than its associated electronic unit.

### Embodiment 45

The apparatus of any of Embodiments 41 through 44, wherein each pixel of the first subset of pixels has a different size than it associated electronic unit.

### Embodiment 46

The apparatus of any of Embodiments 41 through 45, wherein each pixel of the first subset of pixels extends across multiple electronic units in at least one direction.

### Embodiment 47

The apparatus of any of Embodiments 41 through 46, wherein each pixel of the first subset of pixels has a different shape than each pixel of the second subset of pixels.

### Embodiment 48

An apparatus comprising: a plurality of electronic units arranged in an array; a plurality of pixels, each pixel of the plurality of pixels coupled to an associated electronic unit of the plurality of electronic units, wherein each pixel of a first subset of pixels of the plurality of pixels defines a shape that is different than a shape of an associated electronic unit, and a plurality of electrical connections disposed between the plurality of electronic units and the plurality of pixels, wherein each electrical connection connects respective electronic units with an associated pixel.

### Embodiment 49

The apparatus of Embodiment 48, wherein the shape of the first subset of pixels comprises a rectangle, and the shape of the associated electronic units comprises a square.

### Embodiment 50

The apparatus of any of Embodiments 48 through 49, wherein the first subset of pixels is a first material and a second subset of pixels is a second material that is different than the first material.

### Embodiment 51

The apparatus of any of Embodiments 48 through 50, wherein the first material is silicon (Si), and the second material is cadmium telluride (CdTe).

### Embodiment 52

The apparatus of any of Embodiments 48 through 51, wherein each pixel of the first subset of pixels has a different size than its associated electronic unit.

### Embodiment 53

The apparatus of any of Embodiments 48 through 52, wherein each pixel of the first subset of pixels extends across multiple electronic units in at least one direction.

### Embodiment 54

The apparatus of any of Embodiments 48 through 53, wherein the first subset of pixels is configured to convert a charged particle of a first energy level range to an electronic signal; and wherein a second subset of pixels of the plurality of pixels is configured to convert a charged particle of a second energy level range to an electronic signal, wherein the first energy level range and the second energy level range are different.

### Embodiment 55

An apparatus comprising: a plurality of electronic units arranged in an array; a plurality of pixels, each pixel of the plurality of pixels coupled to an associated electronic unit of the plurality of electronic units, wherein each pixel of a first subset of pixels of the plurality of pixels defines a shape that is different than a shape of the associated electronic units; wherein the first subset of pixels of the plurality of pixels is formed from a first material, and wherein a second subset of pixels of the plurality of pixels is formed from a second material, the first material being different than the first material, and a plurality of electrical connections disposed between the plurality of electronic units and the plurality of pixels, where each electrical connection connects respective electronic units with an associated pixel.

### Embodiment 56

The apparatus of Embodiment 55, wherein the first material is silicon (Si), and the second material is cadmium telluride (CdTe).

### Embodiment 57

The apparatus of any of Embodiment 55 through 56, wherein at least one of the first material and the second material is formed from stacking a plurality of layers.

### Embodiment 58

The apparatus of any of Embodiment 55 through 57, wherein the shape of each pixel of the first subset of pixels is different than a shape defined by each pixel of the second subset of pixels.

### Embodiment 59

The apparatus of any of Embodiment 55 through 58, wherein each pixel of the first subset of pixels has a different size than their associated electronic unit.

### Embodiment 60

The apparatus of any of Embodiment 55 through 59, wherein each pixel of the first subset of pixels extends across multiple electronic units in at least one direction.

## Claims

1. An apparatus comprising:
a plurality of electronic units arranged in an array;
a plurality of pixels, each pixel of the plurality of pixels coupled to an associated electronic unit of the plurality of electronic units;
wherein a first subset of pixels of the plurality of pixels is formed from a first material, and wherein a second subset of pixels of the plurality of pixels is formed from a second material, the second material being different than the first material; and
a plurality of electrical connections disposed between the plurality of electronic units and the plurality of pixels, where each electrical connection connects a respective electronic unit with an associated pixel.

2. The apparatus of claim 1, wherein the first material is silicon (Si), and the second material is cadmium telluride (CdTe).

3. The apparatus of claim 1, wherein at least one of the first material and the second material is formed from stacking a plurality of layers.

4. The apparatus of claim 1, wherein each pixel of the first subset of pixels has a different shape than its associated electronic unit.

5. The apparatus of claim 1, wherein each pixel of the first subset of pixels has a different size than its associated electronic unit.

6. The apparatus of claim 5, wherein each pixel of the first subset of pixels extends across multiple electronic units in at least one direction.

7. The apparatus of claim 5, wherein each pixel of the first subset of pixels has a different shape than each pixel of the second subset of pixels.
